# EUROPÄISCHE PATENTANMELDUNG

(11) **EP 3 886 246 A1**
(43) Veröffentlichungstag der Anmeldung: **29.09.2021**
(21) Anmeldenummer: 21163886.1
(22) Anmeldetag: 22.03.2021
(51) Int. Cl.: H01Q 1/08, H01Q 21/28, H01Q 25/00, H05K 1/02

(54) **HOCHFREQUENZANORDNUNG MIT EINER VORDERSEITIGEN UND EINER RÜCKSEITIGEN ANTENNE**

(30) Priorität: 26.03.2020 DE 102020203970
(71) Anmelder: Fraunhofer-Gesellschaft zur Förderung der angewandten Forschung e.V., 80686 München (DE)
(72) Erfinder: Ramm, Peter, 80686 München (DE)
(74) Vertreter: Schlenker, Julian

(57) **Zusammenfassung**

Ausführungsbeispiele der vorliegenden Erfindung schaffen eine Hochfrequenzanordnung. Die Hochfrequenzanordnung umfasst ein Hochfrequenzbauelement mit einer Hochfrequenzschaltung. Ferner umfasst die Hochfrequenzanordnung ein flexibles Substrat mit zumindest zwei Antennen, wobei die Hochfrequenzschaltung mit den zumindest zwei Antennen gekoppelt ist, und wobei das flexible Substrat zumindest teilweise um das Hochfrequenzbauelement herum angeordnet ist, wobei zumindest eine erste Antenne der zumindest zwei Antennen benachbart zu einer ersten Seite des Hochfrequenzbauelements angeordnet ist und zumindest eine zweite Antenne der zumindest zwei Antennen benachbart zu einer der ersten Seite gegenüberliegenden zweiten Seite des Hochfrequenzbauelements angeordnet ist.

## Beschreibung

Ausführungsbeispiele der vorliegenden Erfindung beziehen sich auf eine Hochfrequenzanordnung und, im speziellen, auf eine Hochfrequenzanordnung mit einer vorderseitigen und einer rückseitigen Antenne. Weitere Ausführungsbeispiele beziehen sich auf ein Verfahren zur Herstellung einer Hochfrequenzanordnung.

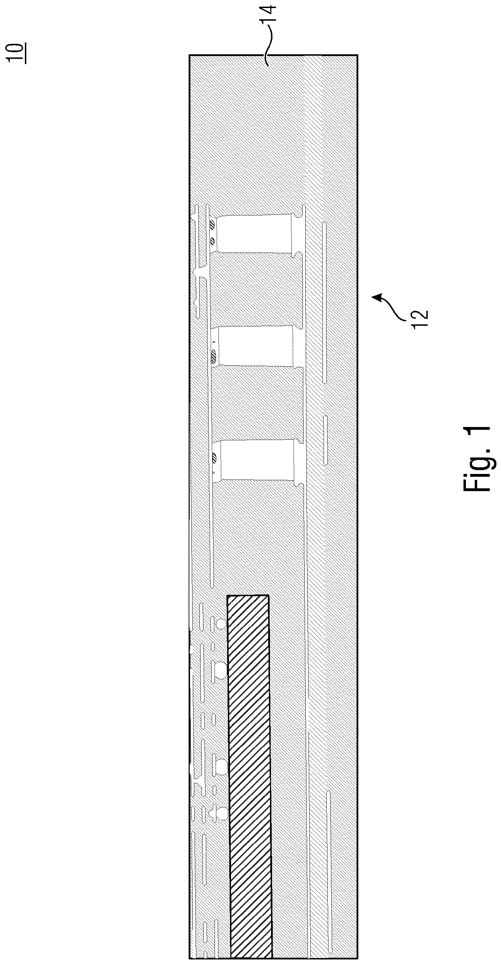

Herkömmlicherweise wird beim Aufbau von Systemen der mobilen Kommunikation die elektrische Verbindung der rückseitigen Antennenstrukturen (engl. Backside Antenna Structures) über vertikale Verbindungen (z.B. sog. Copper Pillars, dt. vertikale, säulenartige Verbindungen aus Kupfer) innerhalb der Leiterplatte (engl. Printed Circuit Board, PCB) realisiert, wie dies beispielhaft in Fig. 1 gezeigt ist.

Im Detail zeigt Fig. 1 eine Querschnittsansicht einer Antennenplatine 10 (engl. Antenna Board) mit rückseitigen Antennenstrukturen 12, die über sog. Copper Pillars 14 (vertikale, säulenartige Verbindungen aus Kupfer) angeschlossen sind [1].

Eine solchen Hochfrequenzschaltung (engl. Radio Frequency Integrated Circuit, RFIC) mit rückseitigen Antennenstrukturen, die über vertikale Verbindungen elektrisch angebunden sind, ist jedoch verhältnismäßig kostspielig und aufwendig in der Herstellung.

Der vorliegenden Erfindung liegt daher die Aufgabe zugrunde eine kostengünstigere und einfacher herzustellende Hochfrequenzschaltung mit rückseitigen Antennenstrukturen zu schaffen.

Diese Aufgabe wird durch die unabhängigen Patentansprüche gelöst.

Vorteilhafte Weiterbildungen finden sich in den abhängigen Patentansprüchen.

Ausführungsbeispiele schaffen eine Hochfrequenzanordnung. Die Hochfrequenzanordnung umfasst ein Hochfrequenzbauelement mit einer Hochfrequenzschaltung. Ferner umfasst die Hochfrequenzanordnung ein flexibles Substrat mit zumindest zwei Antennen, wobei die Hochfrequenzschaltung mit den zumindest zwei Antennen gekoppelt ist, und wobei [z.B. so dass] das flexible Substrat zumindest teilweise um das Hochfrequenzbauelement herum angeordnet ist, wobei zumindest eine erste Antenne der zumindest zwei Antennen benachbart zu einer ersten Seite [z.B. ersten Oberfläche] des Hochfrequenzbauelements angeordnet ist und zumindest eine zweite Antenne der zumindest zwei Antennen benachbart zu einer der ersten Seite gegenüberliegenden zweiten Seite [z.B. zweiten Oberfläche] des Hochfrequenzbauelements angeordnet ist.

Bei Ausführungsbeispielen ist das flexible Substrat zumindest teilweise um das Hochfrequenzbauelement herumgebogen.

Bei Ausführungsbeispielen ist ein erster Abschnitt des flexiblen Substrats, der die zumindest eine erste Antenne aufweist, benachbart zu der ersten Seite des Hochfrequenzbauelements angeordnet wobei ein zweiter Abschnitt des flexiblen Substrats, der die zumindest eine zweite Antenne aufweist, benachbart zu der zweiten Seite des Hochfrequenzbauelements angeordnet ist.

Bei Ausführungsbeispielen liegt ein erster Abschnitt des flexiblen Substrats, der die zumindest eine erste Antenne aufweist, an der ersten Seite des Hochfrequenzbauelements an, wobei ein zweiter Abschnitt des flexiblen Substrats, der die zumindest eine zweite Antenne aufweist, an der zweiten Seite des Hochfrequenzbauelements anliegt.

Bei Ausführungsbeispielen können die zumindest zwei Antennen in unterschiedlichen Ebenen des Hochfrequenzanordnung angeordnet sein.

Bei Ausführungsbeispielen können der erste Abschnitt des flexiblen Substrats und der zweite Abschnitt des flexiblen Substrats in unterschiedlichen Ebenen des Hochfrequenzanordnung angeordnet sein.

Bei Ausführungsbeispielen kann das Hochfrequenzbauelement zwischen den zumindest zwei Antennen angeordnet sein.

Bei Ausführungsbeispielen kann das flexible Substrat eine Metallisierung aufweisen, wobei die Hochfrequenzschaltung mit den zumindest zwei Antennen über die Metallisierung gekoppelt sein kann.

Bei Ausführungsbeispielen ist die Metallisierung in der gleichen Schichtebene des flexiblen Substrats angeordnet wie die zumindest zwei Antennen.

Bei Ausführungsbeispielen ist die Metallisierung in einer anderen Schichtebene des flexiblen Substrats angeordnet als die zumindest zwei Antennen.

Bei Ausführungsbeispielen weist das Hochfrequenzbauelement zumindest einen mit der Hochfrequenzschaltung gekoppelten Anschluss auf, wobei der zumindest eine Anschluss mit der Metallisierung des flexiblen Substrats gekoppelt ist.

Bei Ausführungsbeispielen ist das Hochfrequenzbauelement ein RFIC (Radio Frequency Integrated Circuit, dt. Hochfrequenz-IC).

Weitere Ausführungsbeispiele schaffen ein Mobilfunkgerät, wobei das Mobilfunkgerät eine Hochfrequenzanordnung gem. einem der oben bzw. hierin beschriebenen Ausführungsbeispiele aufweist.

Weitere Ausführungsbeispiele schaffen ein Verfahren zur Herstellung einer Hochfrequenzanordnung. Das Verfahren umfasst ein Bereitstellen eines Hochfrequenzbauelements mit einer Hochfrequenzschaltung. Ferner umfasst das Verfahren ein Bereitstellen eines flexiblen Substrats mit zumindest zwei Antennen. Ferner umfasst das Verfahren ein Anordnen des flexiblen Substrats zumindest teilweise um das Hochfrequenzbauelement herum, so dass zumindest eine erste Antenne der zumindest zwei Antennen benachbart zu einer ersten Seite des Hochfrequenzbauelements angeordnet ist und zumindest eine zweite Antenne der zumindest zwei Antennen benachbart zu einer der ersten Seite gegenüberliegenden zweiten Seite des Hochfrequenzbauelements angeordnet ist. Ferner umfasst das Verfahren ein Verbinden zumindest eines mit der Hochfrequenzschaltung gekoppelten Anschlusses des Hochfrequenzbauelements mit den zumindest zwei Antennen.

Bei Ausführungsbeispielen wird bei dem Anordnen des flexiblen Substrats zumindest teilweise um das Hochfrequenzbauelement herum das flexible Substrat zumindest teilweise um das Hochfrequenzbauelement herumgebogen.

Bei Ausführungsbeispielen wird bei dem Anordnen des flexiblen Substrats zumindest teilweise um das Hochfrequenzbauelement herum ein erster Abschnitt des flexiblen Substrats, der die zumindest eine erste Antenne aufweist, benachbart zu der ersten Seite des Hochfrequenzbauelements angeordnet oder an der ersten Seite des Hochfrequenzbauelements angelegt, wobei bei dem Anordnen des flexiblen Substrats zumindest teilweise um das Hochfrequenzbauelement herum ein zweiter Abschnitt des flexiblen Substrats, der die zumindest eine zweite Antenne aufweist, benachbart zu der zweiten Seite des Hochfrequenzbauelements angeordnet wird oder an der zweiten Seite des Hochfrequenzbauelements angelegt wird.

Bei Ausführungsbeispielen wird bei dem Verbinden zumindest eines mit der Hochfrequenzschaltung gekoppelten Anschlusses des Hochfrequenzbauelements mit den zumindest zwei Antennen der zumindest eine Anschluss des Hochfrequenzbauelements mit zumindest einem mit den zumindest zwei Antennen gekoppelten Anschluss des flexiblen Substrats verbunden.

Bei Ausführungsbeispielen wird bei dem Verbinden zumindest eines mit der Hochfrequenzschaltung gekoppelten Anschlusses des Hochfrequenzbauelements mit den zumindest zwei Antennen eine elektrisch leitende Verbindung zwischen dem Anschluss des Hochfrequenzbauelements und dem Anschluss des flexiblen Substrats erzeugt.

Bei Ausführungsbeispielen werden bei dem Bereitstellen des flexiblen Substrats die zumindest zwei Antennen in dem flexiblen Substrat erzeugt.

Bei Ausführungsbeispielen wird bei dem Bereitstellen des flexiblen Substrats eine Metallisierung, die mit den zumindest zwei Antennen verbunden ist, in dem flexiblen Substrat erzeugt.

Bei Ausführungsbeispielen wird die Metallisierung in der gleichen Schichtebene des flexiblen Substrats erzeugt wie die zumindest zwei Antennen.

Bei Ausführungsbeispielen wird die Metallisierung in einer anderen Schichtebene des flexiblen Substrats erzeugt als die zumindest zwei Antennen.

Bei Ausführungsbeispielen wird bei dem Bereitstellen des flexiblen Substrats eine Verbindung zwischen zumindest einem Anschluss des flexiblen Substrats und der Metallisierung erzeugt.

Weitere Ausführungsbeispiele schaffen Vorrichtung. Die Vorrichtung umfasst ein Hochfrequenzschaltungsbauelement. Ferner umfasst die Vorrichtung mindestens eine elektrisch leitende Verbindung von der Oberseite des Hochfrequenzschaltungssauelementes zu mindestens einem Anschlussmittel. Ferner umfasst die Vorrichtung ein flexibles Substrat mit Antennen in dem flexiblen Substrat, die mit einer Metallisierung elektrisch leitend verbunden sind und mindestens einer elektrisch leitenden Verbindung zwischen dem Anschlussmittel und der Metallisierung, wobei das flexible Substrat um das Hochfrequenzschaltungsbauelement herum angeordnet ist, so dass mindestens eine Antenne sich oberhalb des Hochfrequenzschaltungsbauelementes befindet und mindestens eine Antenne unterhalb des Hochfrequenzschaltungsbauelementes.

Ausführungsbeispiele der vorliegenden Erfindung schaffen einen Systemaufbau für Mobilfunk-Bauelemente unter Verwendung von Hochfrequenzschaltungen (z.B. RFIC) auf einem flexiblen Substrat mit integrierten Antennenstrukturen für Vorderseiten- und Rückseiten-Empfang und -Senden (engl. frontside and backside antenna).

Ausführungsbeispiele der vorliegenden Erfindung schaffen ein Verfahren zur Herstellung von elektronischen Hochfrequenzsystemen, und insbesondere von hochintegrierten, sog. Systems-in-Package (dt. verkapselte Systeme) für den Einsatz in der mobilen Kommunikation.

Ausführungsbeispiele der vorliegenden Erfindung realisieren die elektrische Verbindung von mindestens einer Hochfrequenzschaltung mit Vorder- und Rückseitenantenne über ein spezifisches, flexibles Verdrahtungssubstrat mit integrierten Antennenstrukturen (engl. Frontside and Backside Antenna).

Ausführungsbeispiele der vorliegenden Erfindung werden bezugnehmend auf die beiliegenden Figuren näher beschrieben. Es zeigen:
- Fig. 1: eine Querschnittsansicht einer herkömmlichen Antennenplatine mit rückseitigen Antennenstrukturen, die über sog. Copper Pillars angeschlossen sind [1],
- Fig. 2: eine schematische Querschnittsansicht einer Hochfrequenzanordnung, gemäß einem Ausführungsbeispiel der vorliegenden Erfindung,
- Fig. 3: eine schematische Querschnittsansicht einer Hochfrequenzanordnung, gemäß einem weiteren Ausführungsbeispiel der vorliegenden Erfindung,
- Fig. 4: ein schematisches Blockschaltbild eines Teilnehmers 130 eines Mobilfunksystems mit einer Hochfrequenzanordnung, gemäß einem Ausführungsbeispiel der vorliegenden Erfindung,
- Fig. 5: ein Flussdiagramm eines Verfahrens zur Herstellung einer Hochfrequenzanordnung, gemäß einem Ausführungsbeispiel der vorliegenden Erfindung, und
- Fig. 6: ein Flussdiagramm eines Verfahrens zum Verbinden einer elektrischen Hochfrequenzschaltung mit einer Anordnung von Antennen, gemäß einem Ausführungsbeispiel der vorliegenden Erfindung.

In der nachfolgenden Beschreibung der Ausführungsbeispiele der vorliegenden Erfindung werden in den Figuren gleiche oder gleichwirkende Elemente mit dem gleichen Bezugszeichen versehen, so dass deren Beschreibung untereinander austauschbar ist.

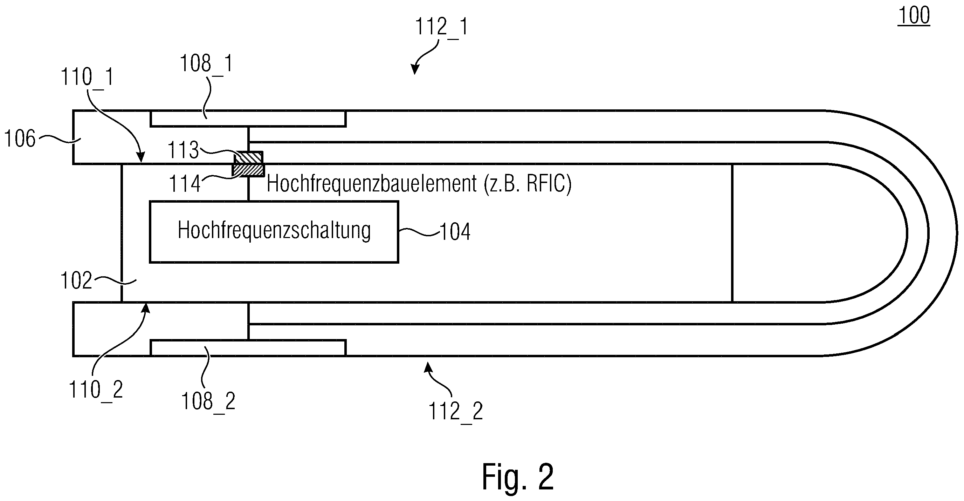

Fig. 2 zeigt eine schematische Querschnittsansicht einer Hochfrequenzanordnung 100, gemäß einem Ausführungsbeispiel der vorliegenden Erfindung. Die Hochfrequenzanordnung 100 weist ein Hochfrequenzbauelement 102 mit einer Hochfrequenzschaltung 104 und ein flexibles Substrat 106 mit zumindest zwei Antennen 108_1 und 108_2 auf, wobei die Hochfrequenzschaltung 100 mit den zumindest zwei Antennen 108_1 und 108_2 gekoppelt (oder verbunden) ist, und wobei das flexible Substrat 106 zumindest teilweise um das Hochfrequenzbauelement 102 herum angeordnet ist, wobei zumindest eine erste Antenne 108_1 der zumindest zwei Antennen 108_1 und 108_2 benachbart zu einer ersten Seite 110_1 des Hochfrequenzbauelements 102 angeordnet ist und zumindest eine zweite Antenne 108_2 der zumindest zwei Antennen 108_1 und 108_2 benachbart zu einer der ersten Seite 110_1 gegenüberliegenden zweiten Seite 110_2 des Hochfrequenzbauelements 102 angeordnet ist.

Bei Ausführungsbeispielen kann die zumindest eine erste Antenne 108_1 somit zumindest eine vorderseitige Antenne der Hochfrequenzanordnung 100 bilden, während die zumindest eine zweite Antenne 108_2 zumindest eine rückseitige Antenne der Hochfrequenzanordnung 100 bilden kann.

Um dies zu realisieren kann das flexible Substrat 106, wie dies in Fig. 2 zu erkennen ist, zumindest teilweise um das Hochfrequenzbauelement 102 herumgebogen sein, z.B. so dass ein erster Abschnitt 112_1 des flexiblen Substrats 106, der die zumindest eine erste Antenne 108_1 aufweist, benachbart zu der ersten Seite 110_1 des Hochfrequenzbauelements 102 angeordnet ist oder an der ersten Seite 110_1 des Hochfrequenzbauelements 102 anliegt, und ein zweiter Abschnitt 112_2 des flexiblen Substrats 106, der die zumindest eine zweite Antenne 108_2 aufweist, benachbart zu der zweiten Seite 110_2 des Hochfrequenzbauelements 102 angeordnet ist oder an der zweiten Seite 110_2 des Hochfrequenzbauelements 102 anliegt.

In Fig. 2 weist die Hochfrequenzanordnung 100 beispielhaft nur zwei Antennen 108_1 und 108_2 auf. Es sei jedoch darauf hingewiesen, dass die Hochfrequenzanordnung 100 bei Ausführungsbeispielen auch mehr als zwei Antennen aufweisen kann. So kann die Hochfrequenzanordnung 100 bis zu n Antennen aufweisen, wobei n eine natürliche Zahl größer gleich zwei ist, n ≥ 2. Hierbei kann zumindest eine erste Antenne der n Antennen benachbart zu der ersten Seite 110_1 des Hochfrequenzbauelements 102 angeordnet sein, während zumindest eine zweite Antenne der n Antennen benachbart zu der zweiten Seite 110_2 des Hochfrequenzbauelements 102 angeordnet sein kann.

Zum Beispiel kann die Hochfrequenzanordnung 100 vier Antennen aufweisen, wobei zumindest eine erste Antenne 108_1 der vier Antennen, wie z.B. eine, zwei, oder drei der vier Antennen, benachbart zu der ersten Seite 110_1 des Hochfrequenzbauelements 102 angeordnet sein können, wobei zumindest eine zweite Antenne 108_2 der vier Antennen, wie z.B. eine, zwei, oder drei der vier Antennen, benachbart zu der zweiten Seite 110_1 des Hochfrequenzbauelements 102 angeordnet sein können.

Bei Ausführungsbeispielen kann das Hochfrequenzbauelement eine Hochfrequenzplatine oder RFIC (Radio Frequenz Integrated Circuit, dt. Hochfrequenz-IC) sein.

Wie dies bereits erwähnt wurde, kann die Hochfrequenzschaltung 104 mit den zumindest zwei Antennen 108_1 und 108_2 gekoppelt sein. Unter einer Kopplung ist hierbei entweder eine direkte Verbindung, z.B. über eine Leitung, oder eine indirekte Verbindung, wie z.B. mit einem zwischengeschalteten Kopplungselement (z.B. kapazitiver Koppler), zu verstehen.

Bei Ausführungsbeispielen kann die Hochfrequenzschaltung 104 über zumindest einen mit der Hochfrequenzschaltung gekoppelten Anschluss 114 des Hochfrequenzbauelements 102 mit den zumindest zwei Antennen 108_1 und 108_2 gekoppelt sein.

Optional kann das flexible Substrat 106 zumindest einen Anschluss 113 aufweisen, der mit den zumindest zwei Antennen 108_1 und 108_2 gekoppelt (oder verbunden) ist. In diesem Fall kann der zumindest eine Anschluss 114 des Hochfrequenzbauelements 102 mit dem zumindest einen Anschluss 113 des flexiblen Substrats gekoppelt (oder verbunden) sein.

Der zumindest eine Anschluss 114 des Hochfrequenzbauelements 102 kann hierbei ausschließlich an einer einzigen Seite des Hochfrequenzbauelements 102 angeordnet sein, wie z.B. an der ersten Seite 110_1 des Hochfrequenzbauelements 102, wie dies in Fig. 2 gezeigt ist, oder alternativ an der zweiten Seite 110_2 des Hochfrequenzbauelements.

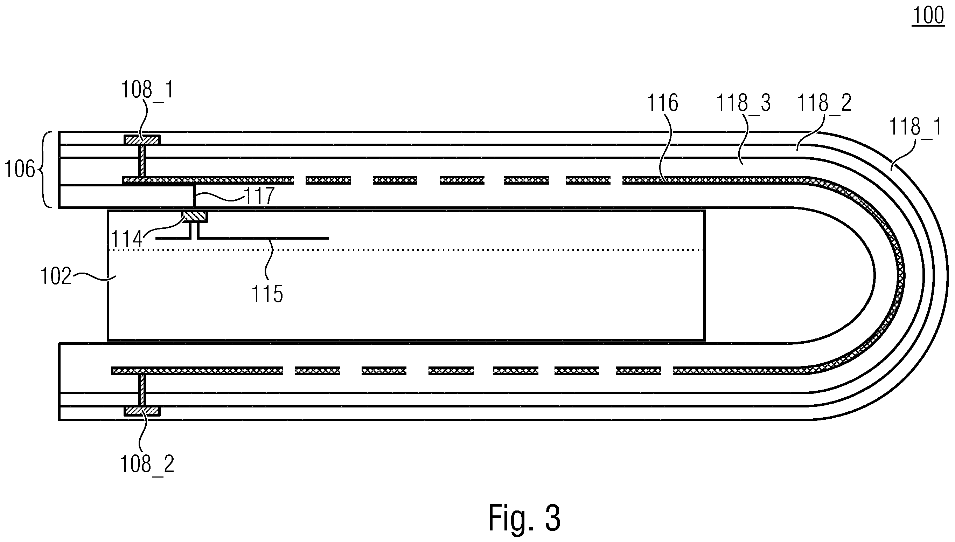

Die zumindest zwei Antennen 108_1 und 108_2 können hierbei über eine Metallisierung mit dem zumindest einen Anschluss 114 gekoppelt (oder verbunden) sein, wie die in Fig. 3 gezeigt ist.

Fig. 3 zeigt eine schematische Querschnittsansicht einer Hochfrequenzanordnung 100, gemäß einem weiteren Ausführungsbeispiel der vorliegenden Erfindung. Ergänzend zu Fig. 2 ist in Fig. 3 die Metallisierung 116 gezeigt, über die die zumindest zwei Antennen 108_1 und 108_2 mit dem zumindest einem Anschluss 114 des Hochfrequenzbauelements 102 gekoppelt (oder verbunden) sind.

Die Metallisierung 116 kann hierbei in einer anderen Ebene des flexiblen Substrats 106 angeordnet sein als die zumindest zwei Antennen 108_1 und 108_2. Beispielsweise kann das flexible Substrat 106, wie dies in Fig. 3 gezeigt ist, drei Ebenen 118_1, 118_2 und 118_3 aufweisen, wobei die zumindest zwei Antennen 108_1 und 108_2 in einer ersten Ebene 118_1 des flexiblen Substrats 106 angeordnet (oder geformt) sein können, während die Metallisierung in einer dritten Ebene 118_3 des flexiblen Substrats 106 angeordnet (oder geformt) sein kann.

Alternativ kann die Metallisierung 116 auch in der gleichen Ebene des flexiblen Substrats 106 wie die zumindest zwei Antennen 108_1 und 108_2 angeordnet (oder geformt) sein, wie z.B. in der ersten Ebene 118_1 des flexiblen Substrats 106. In diesem Fall kann das flexible Substrat auch nur eine einzige Ebene aufweisen.

Mit anderen Worten, Fig. 3 zeigt ein schematisches Blockschaltbild einer Vorrichtung 100, gemäß einem Ausführungsbeispiel. Die Vorrichtung 100 umfasst ein Hochfrequenzschaltungsbauelement 102. Ferner umfasst die Vorrichtung 100 mindestens eine elektrisch leitende Verbindung 115 von der Oberseite des Hochfrequenzschaltungsbauelementes 102 zu mindestens einem Anschlussmittel 114. Ferner umfasst die Vorrichtung 100 ein flexibles Substrat 106 mit Antennen 108_1 und 108_2 in dem flexiblen Substrat 106, die mit einer Metallisierung 116 elektrisch leitend verbunden sind und mindestens einer elektrisch leitenden Verbindung 117 zwischen dem Anschlussmittel 114 und der Metallisierung 116, wobei das flexible Substrat 106 um das Hochfrequenzschaltungsbauelement 102 herum angeordnet ist, so dass mindestens eine Antenne 108_1 sich oberhalb des Hochfrequenzschaltungsbauelementes 102 befindet und mindestens eine Antenne 108_2 unterhalb des Hochfrequenzschaltungsbauelementes 102.

Bei Ausführungsbeispielen kann statt der Metallisierung auch die Schichtebene der Antenne für die elektrische Verbindung der Antenne genutzt werden.

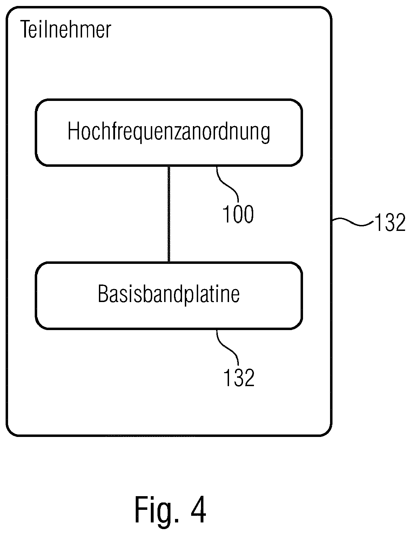

Die oben beschriebene Hochfrequenzanordnung 100 kann beispielsweise in einem Teilnehmer eines Mobilfunksystems implementiert werden, wie dies in Fig. 4 beispielhaft gezeigt ist.

Fig. 4 zeigt ein schematisches Blockschaltbild eines Teilnehmers 130 eines Mobilfunksystems (z.B. 3G, LTE oder 5G) mit einer Hochfrequenzanordnung 100, gemäß einem Ausführungsbeispiel der vorliegenden Erfindung.

Bei Ausführungsbeispielen kann die Hochfrequenzanordnung 100 mit einer Basisbandkomponente 132, wie z.B. einer Basisbandplatine, des Teilnehmers 130 verbunden sein.

Der Teilnehmer 130 kann beispielsweise ein mobiles Endgerät (engl. User Equipment) oder ein IoT-Knoten (loT = Internet of Things, dt. Internet der Dinge) sein.

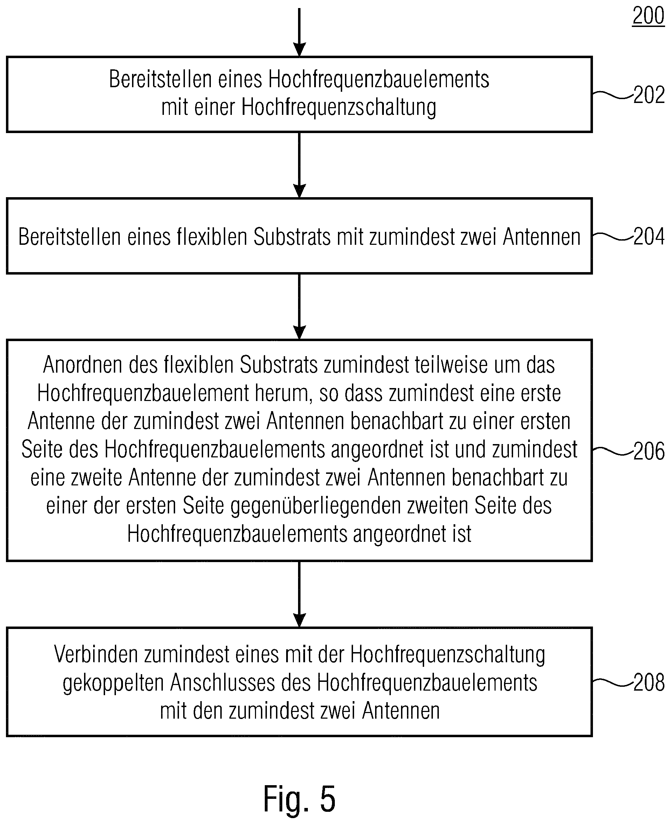

Fig. 5 zeigt ein Flussdiagramm eines Verfahrens 200 zur Herstellung einer Hochfrequenzanordnung, gemäß einem Ausführungsbeispiel der vorliegenden Erfindung. Das Verfahren 200 umfasst ein Schritt des Bereitstellens 202 eines Hochfrequenzbauelements 102 mit einer Hochfrequenzschaltung 104. Ferner umfasst das Verfahren 200 einen Schritt 204 des Bereitstellens eines flexiblen Substrats 106 mit zumindest zwei Antennen 108_1 und 108_2. Ferner umfasst das Verfahren 200 einen Schritt 206 des Anordnens des flexiblen Substrats 106 zumindest teilweise um das Hochfrequenzbauelement 102 herum, so dass zumindest eine erste Antenne 108_1 der zumindest zwei Antennen 108_2 benachbart zu einer ersten Seite 110_1 des Hochfrequenzbauelements 102 angeordnet ist und zumindest eine zweite Antenne 108_2 der zumindest zwei Antennen 108_1 und 108_2 benachbart zu einer der ersten Seite 110_1 gegenüberliegenden zweiten Seite 110_2 des Hochfrequenzbauelements 120 angeordnet ist. Ferner umfasst das Verfahren 200 einen Schritt 208 des Verbindens zumindest eines mit der Hochfrequenzschaltung 104 gekoppelten Anschlusses 114 des Hochfrequenzbauelements 102 mit den zumindest zwei Antennen 108_1 und 108_2.

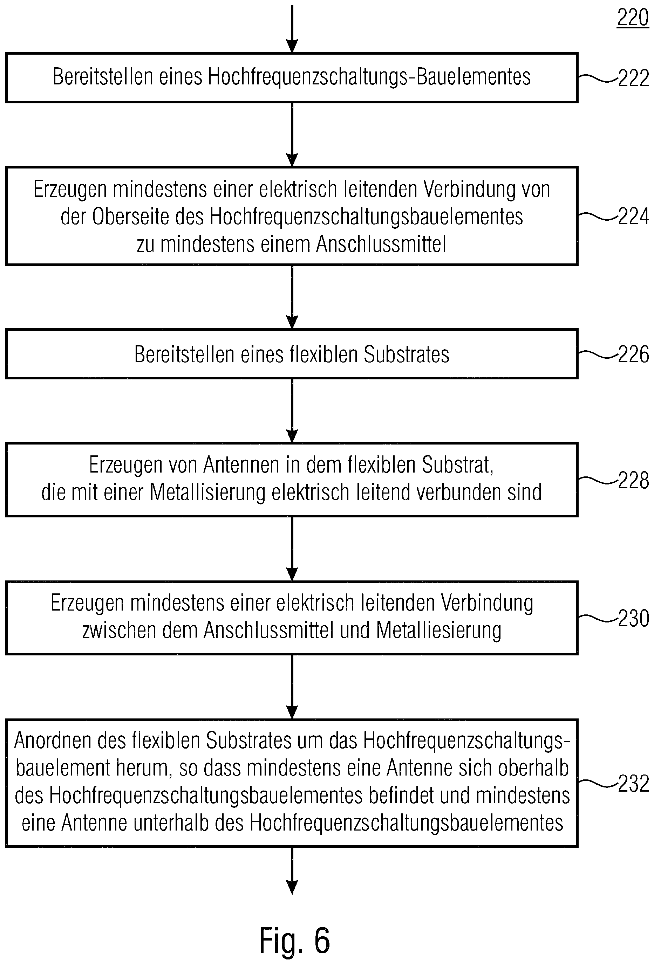

Fig. 6 zeigt ein Flussdiagramm eines Verfahrens 220 zum Verbinden einer elektrischen Hochfrequenzschaltung 102 mit einer Anordnung von Antennen 108_1 und 108_2, gemäß einem Ausführungsbeispiel der vorliegenden Erfindung. Das Verfahren 220 umfasst einen Schritt 222 des Bereitstellens eines Hochfrequenzschaltungsbauelementes 102. Ferner umfasst das Verfahren 220 einen Schritt 224 des Erzeugens mindestens einer elektrisch leitenden Verbindung 115 von der Oberseite des Hochfrequenzschaltungsbauelementes 102 zu mindestens einem Anschlussmittel 114. Ferner umfasst das Verfahren 220 einen Schritt 226 des Bereitstellens eines flexiblen Substrates 106. Ferner umfasst das Verfahren 220 einen Schritt 228 des Erzeugens von Antennen 108_1 und 108_2 in dem flexiblen Substrat 106, die mit einer Metallisierung 116 elektrisch leitend verbunden sind. Ferner umfasst das Verfahren 220 einen Schritt 230 des Erzeugens mindestens einer elektrisch leitenden Verbindung 117 zwischen dem Anschlussmittel 114 und der Metallisierung 116. Ferner umfasst das Verfahren 220 einen Schritt 232 des Anordnens des flexiblen Substrates 106 um das Hochfrequenzschaltungsbauelement 102 herum, so dass mindestens eine Antenne 108_1 sich oberhalb des Hochfrequenzschaltungsbauelementes 102 befindet und mindestens eine Antenne 108_2 unterhalb des Hochfrequenzschaltungsbauelementes 102.

Bei Ausführungsbeispielen kann statt der Metallisierung 116 die Schichtebene der Antenne 108_1 auch für die elektrische Verbindung der Antenne 108_1 genutzt werden. D.h. die Metallisierung für die Antennenansteuerung kann mit demselben Prozessschritt wie die Herstellung der Antennenstrukturen erzeugt werden.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

### Literaturverzeichnis

[1] SystemPlus Report ©2018 by System Plus Consulting | Qualcomm WiGig60 GHz Chipset Smartphone Edition

## Patentansprüche

1. Hochfrequenzanordnung (100), mit folgenden Merkmalen:
einem Hochfrequenzbauelement (102) mit einer Hochfrequenzschaltung (104), und
einem flexiblen Substrat (106) mit zumindest zwei Antennen (108_1, 108_2),
wobei die Hochfrequenzschaltung (104) mit den zumindest zwei Antennen (108_1, 108_2) gekoppelt ist, und
wobei das flexible Substrat (106) zumindest teilweise um das Hochfrequenzbauelement (102) herum angeordnet ist, wobei zumindest eine erste Antenne (108_1) der zumindest zwei Antennen (108_1, 108_2) benachbart zu einer ersten Seite (110_1) des Hochfrequenzbauelements (102) angeordnet ist und zumindest eine zweite Antenne (108_2) der zumindest zwei Antennen (108_1, 108_2) benachbart zu einer der ersten Seite (110_1) gegenüberliegenden zweiten Seite (110_2) des Hochfrequenzbauelements (102) angeordnet ist.

2. Hochfrequenzanordnung (100) nach dem vorangehenden Anspruch,
wobei das flexible Substrat (106) zumindest teilweise um das Hochfrequenzbauelement (102) herumgebogen ist.

3. Hochfrequenzanordnung (100) nach einem der vorangehenden Ansprüche,
wobei ein erster Abschnitt (112_1) des flexiblen Substrats (106), der die zumindest eine erste Antenne (108_1) aufweist, benachbart zu der ersten Seite (110_1) des Hochfrequenzbauelements (102) angeordnet ist oder an der ersten Seite (110_1) des Hochfrequenzbauelements (102) anliegt,
wobei ein zweiter Abschnitt (112_2) des flexiblen Substrats (106), der die zumindest eine zweite Antenne (108_2) aufweist, benachbart zu der zweiten Seite (110_2) des Hochfrequenzbauelements (102) angeordnet ist oder an der zweiten Seite (110_2) des Hochfrequenzbauelements (102) anliegt.

4. Hochfrequenzanordnung (100) nach einem der vorangehenden Ansprüche,
wobei das flexible Substrat (106) eine Metallisierung (116) aufweist,
wobei die Hochfrequenzschaltung (104) mit den zumindest zwei Antennen (108_1, 108_2) über die Metallisierung (116) gekoppelt ist.

5. Hochfrequenzanordnung (100) nach dem vorangehenden Anspruch,
wobei die Metallisierung (116) in der gleichen Schichtebene des flexiblen Substrats (106) angeordnet ist wie die zumindest zwei Antennen (108_1, 108_2),
oder wobei die Metallisierung (116) in einer anderen Schichtebene des flexiblen Substrats (106) angeordnet ist als die zumindest zwei Antennen (108_1, 108_2).

6. Hochfrequenzanordnung (100) nach einem der Ansprüche 4 bis 5,
wobei das Hochfrequenzbauelement (102) zumindest einen mit der Hochfrequenzschaltung (104) gekoppelten Anschluss (114) aufweist,
wobei der zumindest eine Anschluss (114) mit der Metallisierung (116) des flexiblen Substrats (106) gekoppelt ist.

7. Hochfrequenzanordnung (100) nach einem der vorangehenden Ansprüche,
wobei das Hochfrequenzbauelement (102) eine Hochfrequenzplatine oder ein Hochfrequenz-IC ist.

8. Teilnehmer (130) eines Mobilfunksystems,
wobei der Teilnehmer (130) eine Hochfrequenzanordnung (100) nach einem der Ansprüche 1 bis 7 aufweist.

9. Verfahren (200) zur Herstellung einer Hochfrequenzanordnung (100), wobei das Verfahren (200) aufweist:
Bereitstellen (202) eines Hochfrequenzbauelements (102) mit einer Hochfrequenzschaltung (104),
Bereitstellen (204) eines flexiblen Substrats (106) mit zumindest zwei Antennen (108_1, 108_2),
Anordnen (206) des flexiblen Substrats (106) zumindest teilweise um das Hochfrequenzbauelement (102) herum, so dass zumindest eine erste Antenne (108_1) der zumindest zwei Antennen (108_1, 108_2) benachbart zu einer ersten Seite (110_1) des Hochfrequenzbauelements (102) angeordnet ist und zumindest eine zweite Antenne (108_2) der zumindest zwei Antennen (108_1, 108_2) benachbart zu einer der ersten Seite (110_1) gegenüberliegenden zweiten Seite (110_2) des Hochfrequenzbauelements (102) angeordnet ist, und
Verbinden (208) zumindest eines mit der Hochfrequenzschaltung (104) gekoppelten Anschlusses (114) des Hochfrequenzbauelements (102) mit den zumindest zwei Antennen (108_1, 108_2).

10. Verfahren (200) nach dem vorangehenden Anspruch,
wobei bei dem Anordnen (206) des flexiblen Substrats (106) zumindest teilweise um das Hochfrequenzbauelement (102) herum das flexible Substrat (106) zumindest teilweise um das Hochfrequenzbauelement (102) herumgebogen wird.

11. Verfahren (200) nach einem der vorangehenden Ansprüche,
wobei bei dem Anordnen (206) des flexiblen Substrats (106) zumindest teilweise um das Hochfrequenzbauelement (102) herum ein erster Abschnitt (112_1) des flexiblen Substrats (106), der die zumindest eine erste Antenne (108_1) aufweist, benachbart zu der ersten Seite (110_1) des Hochfrequenzbauelements (102) angeordnet wird oder an der ersten Seite (110_1) des Hochfrequenzbauelements (102) angelegt wird,
wobei bei dem Anordnen (206) des flexiblen Substrats (106) zumindest teilweise um das Hochfrequenzbauelement (102) herum ein zweiter Abschnitt (112_2) des flexiblen Substrats (106), der die zumindest eine zweite Antenne (108_2) aufweist, benachbart zu der zweiten Seite (110_2) des Hochfrequenzbauelements (102) angeordnet wird oder an der zweiten Seite (110_2) des Hochfrequenzbauelements (102) angelegt wird.

12. Verfahren (200) nach einem der vorangehenden Ansprüche,
wobei bei dem Verbinden (208) zumindest eines mit der Hochfrequenzschaltung (104) gekoppelten Anschlusses (114) des Hochfrequenzbauelements (102) mit den zumindest zwei Antennen (108_1, 108_2) der zumindest eine Anschluss (114) des Hochfrequenzbauelements (102) mit zumindest einem mit den zumindest zwei Antennen (108_1, 108_2) gekoppelten Anschluss (113) des flexiblen Substrats (106) verbunden wird.

13. Verfahren (200) nach dem vorangehenden Anspruch,
wobei bei dem Verbinden (208) zumindest eines mit der Hochfrequenzschaltung (104) gekoppelten Anschlusses (114) des Hochfrequenzbauelements (102) mit den zumindest zwei Antennen (108_1, 108_2) eine elektrisch leitende Verbindung zwischen dem Anschluss (114) des Hochfrequenzbauelements (102) und dem Anschluss (113) des flexiblen Substrats (106) erzeugt wird.

14. Verfahren (200) nach einem der vorangehenden Ansprüche,
wobei bei dem Bereitstellen (204) des flexiblen Substrats (106) die zumindest zwei Antennen (108_1, 108_2) in dem flexiblen Substrat (106) erzeugt werden.

15. Verfahren (200) nach dem vorangehenden Anspruch,
wobei bei dem Bereitstellen (204) des flexiblen Substrats (106) eine Metallisierung (116), die mit den zumindest zwei Antennen (108_1, 108_2) verbunden ist, in dem flexiblen Substrat (106) erzeugt wird.

16. Verfahren (200) nach dem vorangehenden Anspruch,
wobei die Metallisierung (116) in der gleichen Schichtebene des flexiblen Substrats (106) erzeugt wird wie die zumindest zwei Antennen (108_1, 108_2),
oder wobei die Metallisierung (116) in einer anderen Schichtebene des flexiblen Substrats (106) erzeugt wird als die zumindest zwei Antennen (108_1, 108_2).

17. Verfahren (200) nach einem der Ansprüche 15 bis 16,
wobei bei dem Bereitstellen (204) des flexiblen Substrats (106) eine Verbindung zwischen zumindest einem Anschluss des flexiblen Substrats (106) und der Metallisierung (116) erzeugt wird.
